Europäisches Patentamt

European Patent Office

Office européen des brevets

(19)

(11) Publication number: **0 043 734 B1**

(12) **EUROPEAN PATENT SPECIFICATION**

(45) Date of publication of patent specification: **16.10.85**

(51) Int. Cl.⁴: **H 01 L 31/10,** H 01 L 29/06, H 01 L 21/225

(21) Application number: **81303108.5**

(22) Date of filing: **08.07.81**

(54) Avalanche photodiodes.

(30) Priority: **08.07.80 JP 93025/80**
**28.08.80 JP 118592/80**

(43) Date of publication of application:
**13.01.82 Bulletin 82/02**

(45) Publication of the grant of the patent:
**16.10.85 Bulletin 85/42**

(84) Designated Contracting States:
**DE FR GB NL**

(56) References cited:
**US-A-3 886 579**
**US-A-3 959 646**

**APPLIED PHYSICS LETTERS, Vol. 36, No. 2, 15 January 1980 New York YEATS et al. "Leakage current in InGaAsP avalanche photodiodes" pages 167 to 170**

**JAPANESE JOURNAL OF APPLIED PHYSICS, Vol. 19, No. 7, July 1980 Tokyo MATSUSHIMA et al. "Planar In 0.53 Ga 0.47 As Avalanche Photodiodes with Guard-Ring Structure" pages 1441 to 1442**

(73) Proprietor: **FUJITSU LIMITED**
**1015, Kamikodanaka Nakahara-ku**
**Kawasaki-shi Kanagawa 211 (JP)**

(72) Inventor: **Osaka, Fukunobu**
**979, Kawawa-cho Midori-ku**
**Yokohama-shi Kanagawa 226 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
**APPLIED PHYSICS LETTERS, Vol. 35, No. 3, 1 August 1979 New York NISHIDA et al. "InGaAsP heterostructure avalanche photodiodes with high avalanche gain" pages 251 to 253**

Courier Press, Leamington Spa, England.

## Description

This invention relates to avalanche photodiodes (APD's).

Katsuhiko Nishida et al. reports, in Applied Physics Letters 35 (3) 1 August 1979 pages 251 through 253, that distinct improvements in avalanche-gain and dark-current characteristics have been successfully realized by controlling position of a p-n junction in a window InP layer of an APD having an InGaAsP/InP heterostructure but having no actual guard ring. The report refers to the effects of p-n junction depth on photocurrent and dark-current characteristics, and emphasizes the possibility of making the distance of a p-n junction front from the heterojunction extremely small, for example 0.5 micrometers, by employment of selective diffusion of Cd from a $Cd_3P_2$ source, resultantly realizing the guard ring effect without using an actual guard ring and realizing improved characteristics relating to avalanche-gain and dark-current for an APD consisting of a light absorbing InGaAsP or InGaAs layer and a window InP Layer. The report particularly points out that such improvements are realized without using an actual guard ring.

An APD has a p-n junction which is reverse biased to cause avalanche multiplication of a current of electrons or holes generated by a photoelectric effect in a light absorbing region which is exposed to light which arrives at the light absorbing region after passing through a window layer. The most essential function of the p-n junction is that it allows breakdown to occur exclusively in a central region of a p-n junction formed in the window layer. Therefore, typical APD's available in the prior art are provided with a guard ring configuration in which an abrupt p-n junction is formed in a light sensitive area, this area containing the abrupt p-n junction being surrounded by a graded p-n junction ring, so that breakdown exclusively occurs in the light sensitive area. In addition, the p-n junction is required to have the uniform performance all over the junction front to realize higher grades of avalanche-gain, sensitivity and response and lower values of dark-current and noise.

It is not necessarily difficult to form guard rings having a graded p-n junctions in Si or Ge based APD's. Due to the rather short fundamental absorption edge of Si and also due to unsatisfactory performance of Ge based APD's in other respects, APD's having two independent layers, one of which is a light absorbing layer formed of a semiconductor having a relatively small band gap Eg, and the other of which is a window layer formed of a semiconductor having a relatively large band gap Eg, have increasingly become preferable. It is clear that the semiconductor forming the light absorbing layer determines the sensitive wavelength range of such an APD that the window layer is responsible for providing the avalanche multiplication. A typical combination of the materials for the light absorbing layer and for the window layer is a InGaAsP and InGaAs and InP or GaSb and GaAsSb, albeit these combinations do not have any slightest limiting sense.

It should be particularly noted, however, that it is extremely difficult to form a graded p-n junction in an InP or GaAsSb layer. This is the reason why many attempts have been made to develop InGaAsP or InGaAs based APD's and/or GaSb based APD's which do not require any conventional type actual guard ring. The efforts of Nishida et al, referred to above, fall into this category.

The APD's invented by Nishida et al. have a p-n junction slightly above a heterojunction between a light absorbing InGaAsP or InGaAs layer and a window InP layer. Since the distance between the p-n junction and the heterojunction is quite short, the intensity of electric field in the light absorbing layer becomes non-uniform in the horizontal direction. In other words, the intensity of electric field becomes larger in the central region of the p-n junction than in other regions. This means that intensity of electric field in a light sensitive layer is larger than in other regions. Further, since breakdown voltage is reduced as the band gap of a semiconductor becomes smaller, the breakdown voltage of the light absorbing layer just beneath the central region of the p-n junction becomes the lowest among the neighboring regions including the other region of the light absorbing layer and the window layer, resultantly realizing the guard ring effect.

The inventors of this invention have, however, discovered that the APD's invented by Nishida et al. suffer the following drawbacks. Firstly, it is not necessarily easy to form a p-n junction front slightly above the InGaAsP or InGaAs/InP heterojunction, particularly from a realistic or practical viewpoint. Secondly, since the intensity of electric field is necessarily high in the InGaAsp or InGaAs light absorbing layer facing the light window, tunnel current inevitably occurs in this region, increasing the dark-current as a result, and further resulting in a lesser magnitude of avalanche-gain. It is well-known that the magnitude of tunnel current is larger for semiconductors having a smaller band gap Eg.

Incidentally, it is well-known that the fundamental absorption edge $\lambda$ is determined by an inequality $\lambda \leqslant hc/Eg$. In view of the fact that the signal transmission loss in an optical fiber is less for longer wavelength light and that optoelectronic elements sensitive to longer wavelength light are increasingly preferable, the above-mentioned drawback due to the large amount of tunnel current which is inherent to the semiconductors having a smaller band gap Eg and a longer fundamental absorption edge, such as InGaAsP, InGaAs and GaSb, is fairly significant.

According to the present invention there is provided an avalanche photodiode comprising:
a light absorbing layer of a semiconductor doped with an impurity of one conductivity type, the light absorbing layer being grown on top of a semiconductor substrate of the photodiode, or on top of a buffer layer grown on top of the substrate,

a first window layer of a semiconductor having a larger band gap than that of the light absorbing layer, doped with an impurity of the same conductivity type as that of the impurity of the light absorbing layer, to a concentration at least similar to that of the light absorbing layer, and formed on top of the light absorbing layer,

a second window layer of the same semiconductor as that of the first window layer, doped with an impurity of the same conductivity type as the impurity of the first window layer, to a concentration higher than that of the first window layer, and formed on a limited area of the top surface of the first window layer,

a first electrode electrically connected to an upper region of the second window layer, and

a second electrode electrically connected to the underside of the substrate.

the upper region of the second window layer being doped with an impurity of a conductivity type different from that of the impurity of the second window layer, to a relatively high concentration, to provide a p-n junction for avalance multiplication and to provide a light sensitive region,

the perimeter of the second window layer and an upper region of the first window layer surrounding the perimeter of the second window layer being doped with an impurity of the same conductivity type as that of the upper region of the second window layer, to a relatively high concentration, and to a depth a specific distance above the heterojunction between the light absorbing layer and the first window layer, to provide a p-n junction, for a guard ring effect, at the specific distance above the said heterojunction, which distance is sufficient to prevent tunnelling current from occurring in the region between the p-n junction for a guard ring effect and the said heterojunction.

According to the present invention there is also provided

a method of producing an avalanche photodiode, the method comprising:

a step for growing a light absorbing layer of a semiconductor doped with an impurity of one conductivity type, on top of a semiconductor substrate of the photodiode, or on top of a buffer layer grown on top of the substrate,

a step for growing a first window layer of a semiconductor having a larger band gap than that of the semiconductor of the light absorbing layer and which is doped with an impurity of the same conductivity type as that of the light absorbing layer, to a concentration at least similar to that of the light absorbing layer, on top of the light absorbing layer,

a step for growing a second window layer of the same semiconductor as that of the first window layer and which is doped with an impurity of the same conductivity type as that of the first window layer, to a concentration higher than that of the first window layer, on top of the first window layer,

a step for removing a limited portion of the second window layer to produce a mesa configuration for the second window layer,

a step for providing a relatively high doping concentration of an impurity of a different conductivity type from that of the second window layer in an upper region of the mesa of the second window layer and in an upper region of the first window layer surrounding the mesa of the second window layer, to provide a p-n junction, for a guard ring effect, between the said upper region (28) of the first window layer and a lower region of the first window layer at a specific distance above the heterojunction between the light absorbing layer and the first window layer, which distance is sufficient to prevent tunnelling current from occurring in the region between the said p-n junction and the said heterojunction,

a step for growing a first electrode electrically connected to the upper region of the mesa of the second window layer, and

a step for growing a second electrode electrically connected to the under side of the substrate.

An embodiment of this invention can provide an APD, sensitive in the wavelength range 1.2 micrometers to 1.65 micrometers, which has a light absorbing layer of a semiconductor and a window layer of a semiconductor having a larger band gap than that of the light absorbing layer, and wherein a guard ring configuration is provided which readily realizes an efficient guard ring effect without an accompanying tunnel current problem, resulting in higher grades of avalanche-gain, sensitivity and response and lower values of dark-current and noise.

Another embodiment of this invention can provide a method of production of an APD as mentioned above, wherein the impurity diffusion is simplified, specifically to enable stepped diffusion to be provided in one process step at a reduced temperature and in a reduced diffusion time, to remove or reduce the possibility of producing crystal defects in active or sensitive layers, in addition to providing the advantage of a reduced number of steps and a reduced processing time.

An APD embodying the present invention is provided with (a) one n-or p-doped semiconductor substrate of, for example, InP or GaSb having an electrode on one surface thereof (b) one light absorbing layer of a semiconductor, for example InGaAsP or InGaAs in the case of a InP substrate or GaSb in the case of a GaSb substrate, doped with the same conductivity type impurity as that of the substrate in a relatively low concentration, the light absorbing layer being grown on the substrate or preferably on a buffer layer interposed between the substrate and the light absorbing layer, (c) one first window layer of a semiconductor having a larger band gap Eg than that of the semiconductor of the light absorbing layer, for example, InP in the case of InGaAsP or InGaAs light absorbing layer or GaAsSb in the case of GaSb light absorbing layer, doped with the same conductivity type impurity as that of the light absorbing layer in a concentration similar to or slightly higher than that of the light absorbing layer, and (d) one second window layer of the same semiconductor as that of the first window layer, doped with the same conductivity type impurity as that of the first window layer but in a relatively high concentration, (e) the second window layer having a thin layer highly doped with an impurity of a conductivity type different from the second window layer properly within a limited area or a light sensitive region, preferably the central area of the top surface of the second window layer, (f) the thin highly doped area or the light window being surrounded by a deep closed loop or a guard ring highly doped with an impurity of the same conductivity as that of the thin doped layer, (g) the deep highly doped closed loop or the guard ring extending into the first window layer, there remaining between the guard ring bottom front and the heterojunction between the first window layer and the light absorbing layer a distance sufficient to prevent tunnel current from occurring in this region, for example a distance of 0.5 or 0.8 micrometers, (h) parts of the second window layer in regions surrounding the deep highly doped closed loop or the guard ring being removed, and (i) the light window having another electrode on a portion thereof, preferably on an area surrounding the light window.

When an APD having the abovementioned configuration is reverse biased, a depletion layer extends downwards much more deeply beneath the guard ring than beneath the light sensitive region as a result making the breakdown voltage much less in the light sensitive region than in the region under the guard ring. As a result, avalanche multiplication occurs uniformly in the whole of the light sensitive region. Further, as described above, the tunnel current is effectively prevented from occurring even under the guard ring.

It is not necessary to mention the wavelength ranges to which the above mentioned compound semiconductors, mentioned by way of example, are sensitive; they do not have any limiting effect on this invention. However, it will be understood that an APD sensitive to the wavelength range 1.2 micrometers to 1.65 micrometers, having higher grades of avalanche-gain, sensitivity and response and lower values of dark-current and noise can be successfully provided by an embodiment of this invention.

In order to produce the APD presented above, two independent impurity diffusion steps are generally required, to provide features as described in items (e), (f) and (g) above. Further, the diffusion for production of the deep highly doped closed loop or the guard ring need be long and effected at a high temperature. This could easily result in a drawback in that crystal defects could be produced in the active or sensitive layer.

In order to remove this drawback, a method embodying the present invention for production of the APD as presented above comprises steps in which (a) a light absorbing layer, one first window layer and one second window layer are grown on a substrate or, preferably, on a buffer grown on the substrate, (b) the second window layer is partly removed, leaving a portion thereof corresponding to a light sensitive region, as a result producing a mesa configuration of the second window layer on the area corresponding to the light sensitive region, (c) diffusion is effected for the top surface of the mesa and the surrounding region, with impurities of a different conductivity, to a uniform depth from the top surface of the mesa and the top surface of the surrounding region, producing a shallow diffused region in the light sensitive region and a deep diffused region in the guard ring surrounding the light sensitive region (d) an anti-reflection coat and an insulator layer are produced on top of the second and first window layers excepting on the area on which an electrode is provided, and (e) another electrode is produced on the bottom surface of the substrate. Accordingly, a method embodying the present invention, for production of the APD presented above, is provided, wherein an improvement is made which simplifies impurity diffusion, specifically to enable a stepped diffusion to be effected in one process step with a reduced diffusion temperature in a reduced diffusion time, resultantly removing the possibility of producing crystal defects in the active or sensitive layers, in addition to providing an advantage of reduced number of process steps and the reduced process time.

This invention relates to improvements applicable to avalanche photodiodes, more specifically to the provision of an improved guard ring configuration giving more reliable performance which allows breakdown exclusively in the central region of a p-n junction formed in a window layer, or a multiplication layer, through which light passes to reach the light absorbing layer (Hereinafter referred to as the guard ring effect), and a lesser tunnel current originating in and flowing through the light absorbing layer. An embodiment of this invention can provide an APD which is sensitive to light in the wavelength range 1.2 to 1.65 micrometers, and which comprises a combination of a light absorbing layer of a semiconductor having a relatively small band gap Eg and a window layer of a semiconductor having a relatively large band gap Eg. Typical combinations are InGaAsP or InGaAs and InP or GaSb and GaAsSb.

Reference is made, by way of example, to the accompanying drawings, in which:—

Figure 1 is a schematic sectional view showing the layer configuration of a wafer for providing an APD in accordance with an embodiment of this invention after completion of a fourth production step,

Figure 2 is a schematic sectional view showing the layer configuration of a wafer for providing an APD in accordance with an embodiment of this invention after the completion of a fifth production light sensitive region. The thickness of the second tion step, or after a p-n junction for avalanche multiplication is produced,

Figure 3 is a schematic sectional view showing the layer configuration of a wafer for providing an APD in accordance with an embodiment of this invention after the completion of a sixth production step, or after a guard ring is provided,

Figure 4 is a schematic sectional view showing the layer configuration of a wafer for providing an APD in accordance with an embodiment of this invention after the completion of a seventh production step, or after a portion of the second InP window surrounding a light sensitive region is removed,

Figure 5 is a schematic sectional view showing a layer configuration of a wafer for providing an APD in accordance with an embodiment of this invention after the completion of an eighth production step, or a light window is covered by an anti-reflection coat and a top surface of second and first InP window layers, excluding an area on which an electrode is scheduled to be produced, is covered by a passivation film,

Figure 6 is a schematic sectional view showing the layer configuration of a wafer for providing an APD in accordance with an embodiment of this invention after the completion of ninth production step, or the finished APD,

Figure 7 is a schematic sectional view showing the extent of depletion regions when a reverse bias is applied to an APD having a configuration as shown in Figure 6,

Figure 8 is a graph illustrating intensity of electric field vs. the downward distance from the top surface of a second InP window layer in the light sensitive region of an APD having a configuration as shown in Figure 6,

Figure 9 is a graph illustrating intensity of electric field vs. the downward distance from the top surface of the second InP window layer facing the guard ring of an APD having a configuration as shown in Figure 6,

Figure 10 is a schematic sectional view showing the layer configuration of a wafer for providing an APD in accordance with another embodiment of this invention showing the position after completion of a fifth production step, or when a second window InP layer is etched to form a mesa shape,

Figure 11 is a schematic sectional view showing the layer configuration of a wafer for providing an APD in accordance with the embodiment of this invention of Figure 10, after the completion of a sixth production step, or when a p-n junction for avalance multiplication and for guard ring effect is produced,

Figure 12 is a schematic sectional view of the layer configuration of a wafer for providing an APD in accordance with the embodiment of this invention of Figure 10, showing the position after the completion of a seventh production step, or after the light sensitive region is covered by an anti-reflection coat and the top surface of the second and first window InP layers, excluding the area on which an electrode is scheduled to be produced, is covered by a passivation film, and

Figure 13 is a schematic sectional view of the layer configuration of a wafer for providing an APD in accordance with the embodiment of this invention of Figure 10 after the completion of eighth step, or the finished APD.

For the sake of clarity and simplicity, the following description will be given for an APD in accordance with an embodiment of this invention which is provided with an n-doped InP substrate, and n-doped InP buffer, an n-doped InGaAsP light absorbing layer, an n-doped InP first window layer and an n-doped InP second window layer, an upper portion of the second window layer being doped with a p-type impurity to form a light sensitive region and a portion of the second and first layers surrounding the light sensitive region being doped with a p-type impurity to form a guard ring, and a portion of the second window InP layer surrounding the guard ring being removed as specified.

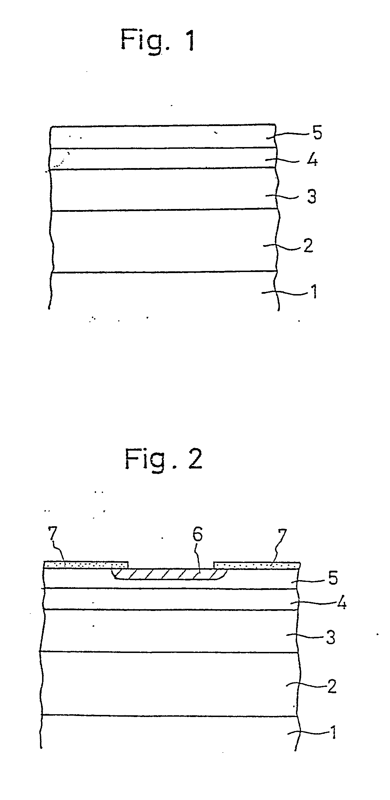

Referring to Figure 1, firstly a liquid phase epitaxial process is employed to grow InP buffer layer 2 having a thickness of about 10 micrometers on an InP substrate 1 doped to $10^{16}$/cm³-concentration. The purpose of this step is of course to improve the crystal quality. The second step is to employ liquid phase epitaxial process to grow a lattice-matched light absorbing InGaAsP layer 3 having a thickness of 2 micrometers doped to a relatively low concentration, for example $10^{16}$/cm³, on the InP substrate 1 or preferably on the InP buffer layer 2. The thickness of the light absorbing layer 3 is selected so as to be sufficient to allow absorption of light and allow downward extension of a depletion region beneath the guard ring inherent to this embodiment of the present invention. Therefore, a thickness of 2 micrometers is generally preferred, albeit some limitations may be imposed by the specific epitaxial process employed. The third step is to employ liquid phase epitaxial process to grow a lattice-matched first window InP layer 4, having a thickness of 1 micrometer doped to a concentration similar to or slightly higher than that of the light absorbing InGaAsP layer 3, or to $2 \times 10^{16}$/cm³-concentration. The thickness of the first window InP layer 4 is selected to be sufficient to allow formation of a p-n junction therein, with a distance remaining betwen the p-n junction bottom front and the heterojunction between the first window InP layer 4 and the light absorbing InGaAsP layer 3 which is sufficient to prevent tunnel current from occurring therein, or such a distance of approximately 0.5 micrometers. Therefore, as described above, the thickness of the first window InP layer 4 is selected to be approximately 1 micrometer, albeit some limitations may be imposed by the specific epitaxial process employed. The fourth step is to employ liquid phase epitaxial process to grow a lattice-matched second window InP layer 5 having a thickness of 1 micrometer doped to a high concentration, for example, to $4 \times 10^{16}$/cm³. A higher doping in this second window InP layer is preferable to reduce breakdown voltage in the InP layer 5 is selected to be sufficient to allow formation of a p-n junction therein.

Referring to Figure 2, a highly p-doped region 6 is produced on the top surface of the second window InP layer 5. This fifth step can be effected either by Cd diffusion from a $Cd_3P_2$ source or by Cd ion implantation employing a $SiO_2$ mask 7. A higher doping and a lesser thickness are preferable for this region 6. Since these requirements may conflict to a degree, a 0.5 micrometer thickness and a doping concentration of $10^{18}/cm^3$ is realistic.

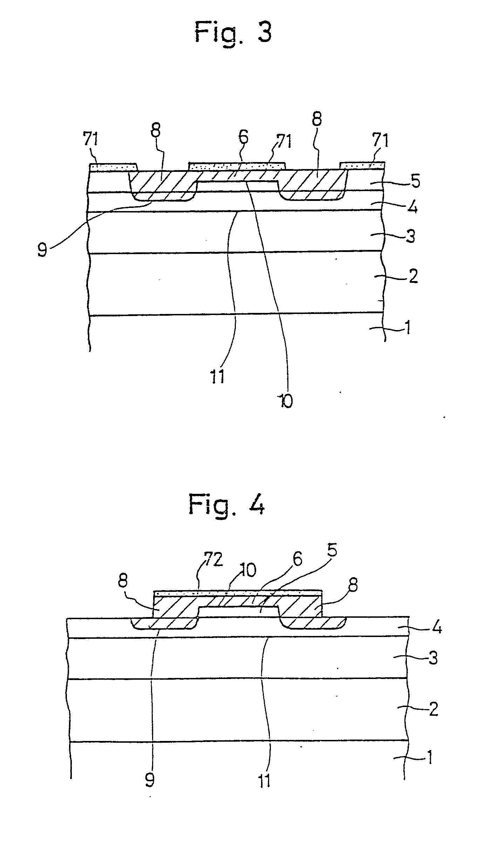

Referring to Figure 3, a highly p-doped deep closed loop or a guard ring 8 is produced to surround the highly p-doped region 6. This sixth step can be effected in a similar way to the fifth step but employing a $SiO_2$ mask 71. This guard ring 8 must reach the first window InP layer 4. The p-n junction 9 between the guard ring 8 and the first window InP layer 4 is required to be separated from the p-n junction 10 between the highly p-doped region 6 and the second window InP layer 5. Further, the p-n junction 9 is required to be separated from the heterojunction 11 between the first window InP layer 4 and the light absorbing InGaAsP layer 3 to prevent tunneling current from occurring in this region. Therefore, 1 micrometer and 0.5 micrometers are respectively releastic for the distances between the heterojunction 11 and the p-n junctions 10 and 9.

Referring to Figure 4, the seventh step is to etch a region of the second window InP layer 5 surrounding the guard ring 8, employing a $SiO_2$ mask 72. After this etching, a portion of the second window InP layer 5 remains in the form of a mesa.

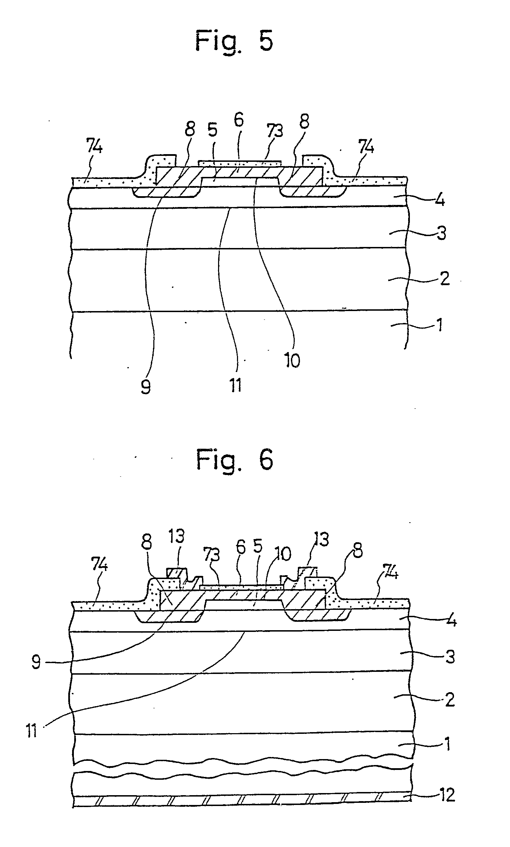

Referring to Figure 5, the eighth step is to remove the $SiO_2$ mask 72, before producing a $SiO_2$ anti-reflection coating 73 on the highly p-doped region 6 to make a light sensitive region. The thickness of this anti-reflection coating 73 is preferably as little as possible. Therefore, a 2,000Å-thickness is realistic. An area is left uncovered by the anti-reflection coating 73 on which an electrode is to be produced in a next process step, whilst top surfaces of the second window InP layer and the first window InP layer 4 are covered by a thick insulator film 74 of $SiO_2$ or PSG, or the like, for the purpose of passivation.

Referring to Figure 6, the ninth step is to produce an electrode 12, for example, AuGe, beneath the undersurface of the InP substrate 1 and an electrode, preferably a ring shaped electrode 13, of for example AuZn, on the uncovered portion of the top surface of the second window InP Layer 5. Evaporation can realistically be employed for implementation of this process.

In operation, an APD having the above described configuration has a positive potential applied to the electrode 12 and a negative potential applied to the electrode 13. Since these potentials function for reverse bias of the p-n junction 10 for avalanche multiplication and of the p-n junction 9 for a guard ring effect, depletion regions extend to both sides of these p-n junctions.

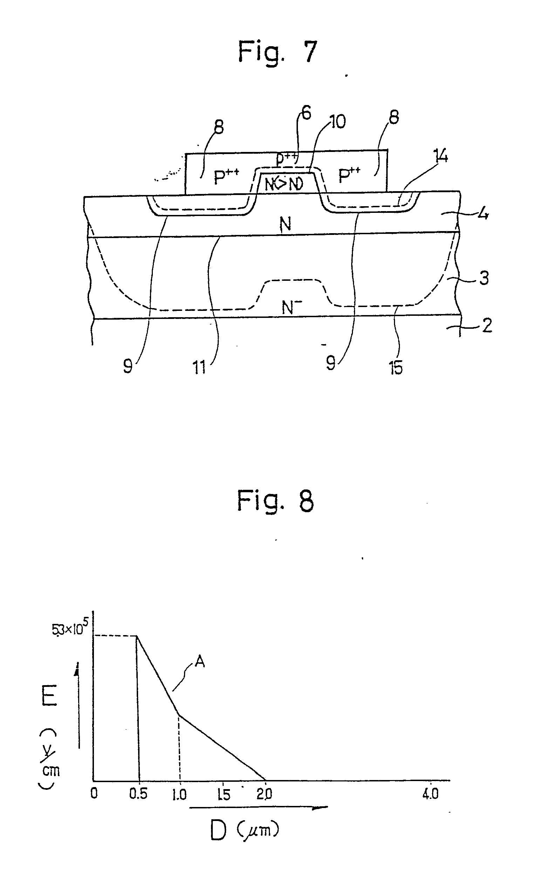

Since the extension of a depletion region depends on the doping concentration of or the amount of majority carriers in the region, the extensions of the depletion regions across and to both sides of the p-n junctions 10 and 9 can be understood to be as shown in Figure 7 from solely qualitative considerations.

In other words, the concentration of the p-doped region (on the p-side, or upper side as seen in Figure 7, of the p-n junctions) is extremely high, for example, $10^{18}/cm^3$ or more, for the both p-n junctions 10 and 9, so the extension of the p-side depletion region is extremely small as shown by a curve 14 in Figure 7. On the other hand, the concentration of the n-doped region facing the light sensitive region of avalanche p-n junction 10 is $4 \times 10^{16}/cm^3$ in the second InP layer 5, $1-2 \times 10^{16}/cm^3$ in the first window InP layer 4, or $10^{16}/cm^3$ in the light absorbing InGaAsP layer 3, and the concentration of the n-doped region facing the guard ring 8 is $1-2 \times 10^{16}/cm^3$ in the first window InP layer 4 or $10^{16}/cm^3$ in the light absorbing InGaAsP layer. Therefore, the contour of the edge of the depletion region to the n-side, or lower side as seen in Figure 7, becomes non-uniform shown as a curve 15.

As a result, the cumulative depletion region extension becomes larger in the regions facing the guard ring p-n junction 9 than in the regions facing the avalanche p-n junction 10. It is clear that the reverse bias is applied across the depletion region, and the intensity of electric field becomes larger in the region facing the light sensitive region than in the region facing the guard ring 8, resultantly causing a prior breakdown in the region facing the avalanche p-n junction 10 or the light sensitive region.

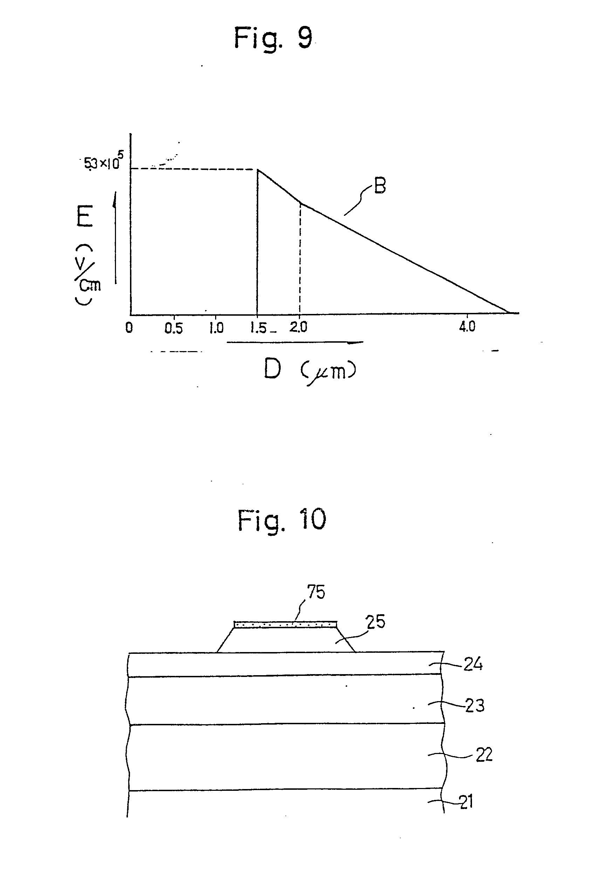

Figures 8 and 9 more clearly illustrate depletion region extension edges. Just for convenience of description, the thicknesses of the second window InP layer 5, the first window InP layer 4 and the light absorbing InGaAsP layer 3 are taken respectively as 1 micrometer, 1 micrometer and 2 micrometers. Further, the avalanche p-n junction 10 and the guard ring p-n junction 9 are assumed to be at locations spaced from the top surface of the second window InP layer 5 respectively by 0.5 micrometers and 1.5 micrometers. Solid lines A and B in Figures 8 and 9 show the relationships between intensity of electric field and the downward distance from the top surface of the second window InP layer respectively in the light sensitive region or the avalanche p-n junction 10 and in the region facing the guard ring p-n junction 9, upon occurrence of breakdown. Since breakdown occurs whenever the intensity of electric field at a p-n junction exceeds a specific amount, the maximum electric field intensity shown on the Y-axis is the same both for Figure 8 and 9. Since the intensity of electric field is maximum at a p-n junction, the locations at which the intensity of electric field is maximum are located at points spaced from the top surface of the second window InP layer 5 respectively by 0.5 micrometers and by 1.5 micrometers. The slope of the solid lines A and B is determined by the doping concentrations of each specific layer, as shown in the Figures. The area bounded by a solid line A or B and by the X-axis shows breakdown voltage. As a result, the breakdown voltage can be seen to be 72V for the region facing the guard ring p-n junction 9 and the breakdown voltage can be seen to be 39V for the region facing the avalanche p-n junction 10, satisfying the requirement to allow breakdown exclusively in the light sensitive region or the avalanche p-n junction 10.

On the other hand, when breakdown occurs in the light sensitive region or the avalanche p-n junction 10, the intensity of electric field around the guard ring p-n junction 9 is less than that around the avalanche p-n junction 10 by several tens of percent, the tunnel current remains less than $10^{-9}$A, on the assumption that the diameter of the avalanche p-n junction 10 is 100 micrometers. This is a magnitude negligible in comparison with dark-current arising from other courses, resultantly satisfying the requirement to reduce the effects of tunnel current.

Breakdown voltage would inevitably become less in the region surrounding the guard ring p-n junction 9. Therefore, this region is removed to prevent this effect occurring.

As described above in detail, an embodiment of this invention can provide an APD sensitive to the wavelength range 1.2 micrometers to 1.65 micrometers which has a guard ring configuration which readily realizes an efficient guard ring effect without an accompanying tunnel current problem as a result providing higher grades of avalanche-gain, sensitivity and response and with lower values of dark-current and noise.

As described above, a difference between the locations of the avalanche p-n junction 10 and the guard ring p-n junction 9 is essential. Therefore, two indpendent impurity diffusion steps are generally required for production of an APD embodying this invention. Further, particularly in order to produce the deep highly doped closed loop or the guard ring 8, a long diffusion period at a high temperature is generally required. This could readily give rise to thermal strain between the SiO₂ mask 71 and the second active InP layer 5, as a result producing crystal defects in the 1,000Å-thick top region of the second active InP layer 5. Since the avalanche p-n junction 10 is often produced in the region containing crystal defects in a later step, APD's produced employing such a method could be inclined to provide a less satisfactory avalanche-gain due to non-uniform breakdown voltage over the entire area of the avalanche p-n junction.

In order to remove this drawback, the inventors of this invention have evolved an improved method for production of an APD embodying the present invention.

Solely in order to give description of a variety of APD's embodying the present invention, the following description will be given of a method of producing an APD in accordance with another embodiment of this invention, having a layer configuration of InGaAsP and InP n-doped to concentrations different from those of the embodiment described with reference to Figures 1 to 6 and which method involves only one impurity diffusion process step after a portion of the second window InP layer has been etched to leave a mesa to form a light sensitive region.

Liquid phase epitaxial process is employed to grow a buffer InP layer 22 having a thickness of several micrometers on an InP substrate 21, before growing a lattice matched light absorbing InGaAsP layer 23 having the thickness of 2 micrometers doped to a relatively low concentration, for example $5 \times 10^{15}$—$1 \times 10^{16}$/cm³, thereon. The third step is to employ liquid phase epitaxial process to grow a lattice matched first window InP layer 24 having the thickness of 1.2 micrometers doped to the concentration of, for example, $1 \times 10^{16}$—$5 \times 10^{16}$/cm³ and a lattice matched second window InP layer 25 having the thickness of 1.5 micrometers doped to a high concentration, for example, $1 \times 10^{16}$—$5 \times 10^{16}$/cm³.

Referring to Figure 10, a SiO₂ film 75 having a thickness of 3,000Å is produced on top of the second window InP layer 25, before photolithography is employed, to make a mask covering an area on which a light sensitive region is scheduled to be produced. The fifth step is to allow a 50° C-liquid containing the same quantities of H₂SO₄ H₂O₂ and H₂O to make contact with the wafer for 15 minutes. Since the etching rate of the liquid for n-doped InP is 0.1 micrometers/min, the second window InP layer 25 is removed, leaving only a mesa covered by the mask 75.

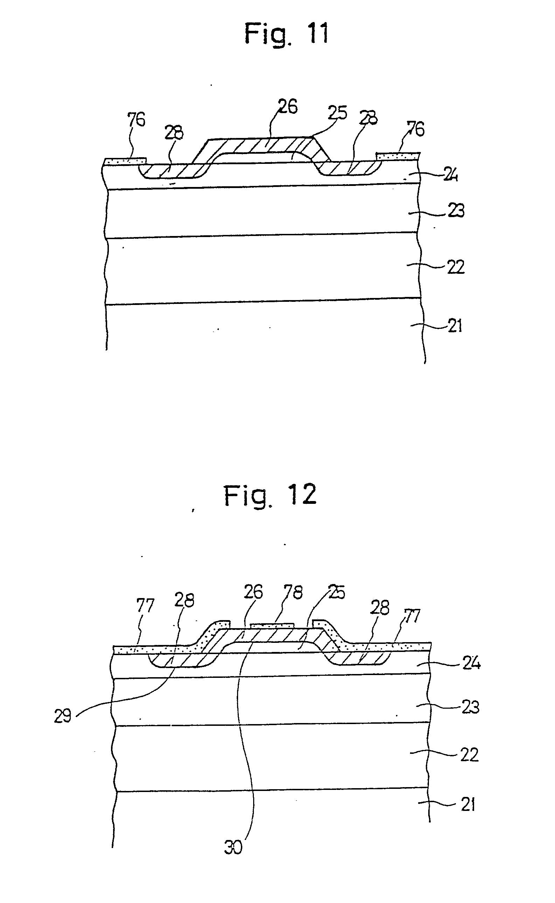

Referring to Figure 11, a different SiO₂ mask 76 is formed on the top surface of the first window InP layer 24, except on an area in which an avalanche p-n junction and a guard ring p-n junction are scheduled to be produced, after mask 75 is removed. Cd diffusion is effected employing a CdP₂ source at a temperature of 500°C for 30 minutes to produce a 0.8 micrometer thick Cd-doped layer. The Cd-doped layer 26 on the second window InP layer 25 makes an avalance p-n junction 30 and the Cd-doped layer 28 on the first window InP layer 24 makes a guard ring p-n junction, 29.

Referring to Figure 12, a seventh step is to produce a SiO₂ anti-reflection coat 78 on the Cd doped layer 26 to make a light window, and to produce a thick insulation film 77 of SiO₂, PSG or the like on the top surfaces of the second window InP layer 25 and the first window InP layer 24 for the purpose of passivation, leaving exposed an area on which an electrode is scheduled to be produced in the next step.

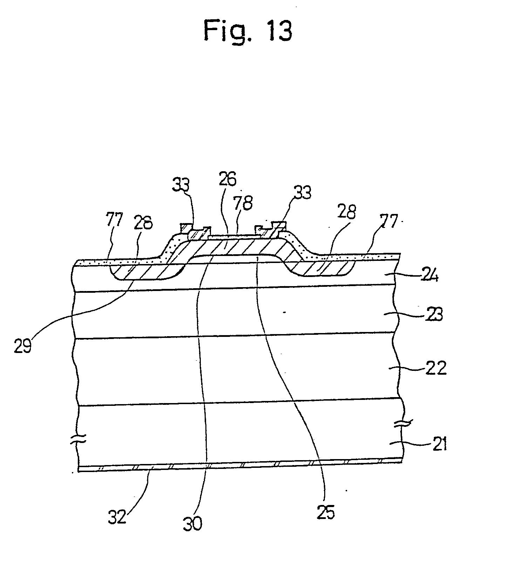

Referring to Figure 13, an eighth step is to produce an electrode 32 of, for example, AuGe beneath the undersurface of the InP substrate 21 and an electrode, preferably a ring shaped electrode, 33 of, for example, AuZn on the exposed area of the top surface of the second window InP layer 25.

Since the n-doping concentration is $1 \times 10^{16}$/cm$^3$ for the light absorbing InGaAsP layer 23 and for the first window InP layer 24 and the n-doping concentration is $3 \times 10^{16}$/cm$^3$ for the second window InP layer 25, the breakdown voltage of the region facing the avalanche p-n junction 30 or the light sensitive region is observed to be 51V and the breakdown voltage of the region facing the guard ring p-n junction 29 is observed to the 80V, satisfying the requirements to allow breakdown exclusively in the light sensitive region or the avalanche p-n junction 30.

As described above in detail, a method is provided in accordance with an embodiment of the present invention for production of an APD as described above, wherein simplification of impurity diffusion steps is provided, specifically to enable stepped diffusion to be produced in one process step with a reduced diffusion temperature in a reduced diffusion time, as a result removing the possibility of producing crystal defects in active or sensitive layers, in addition to providing reduced process time.

An embodiment of the present invention can provide an avalanche photodiode sensitive to the wavelength range 1.2 to 1.65 micrometers which is provided with a light absorbing layer and first and second window layers of a semiconductor having a band gap larger than the semiconductor of the light absorbing layer, grown on a substrate. All the layers are doped with the same conductivity type impurity but the doping concentration is higher for the second window layer than for the first window layer. A p-n junction for avalanche multiplication is produced in the second window layer and another deep p-n junction, for providing a guard ring effect, is produced around the avalanche p-n junction so as to reach the first window layer but to be spaced a specific distance above the heterojunction between the first window layer and the light absorbing layer. Under a reverse bias, a much deeper depletion region extends in the regions facing the guard ring p-n junction than in the region facing the avalanche p-n junction, and thereby breakdown is allowed to occur exclusively and uniformly in the region facing the avalanche p-n junction, as a result realizing higher grades of avalanche-gain, sensitivity and response and lower values of dark-current and noise. In addition, an improved method for production of an avalanche photodiode is disclosed.

## Claims

1. An avalanche photodiode comprising:
a light absorbing layer (3; 23) of a semiconductor doped with an impurity of one conductivity type, the light absorbing layer (3; 23) being grown on top of a semiconductor substrate (1; 21) of the photodiode, or on top of a buffer layer (2; 22) grown on top of the substrate (1; 21),

a first window layer (4; 24) of a semiconductor having a larger band gap than that of the light absorbing layer (3; 23), doped with an impurity of the same conductivity type as that of the impurity of the light absorbing layer (3, 23), to a concentration at least similar to that of the light absorbing layer (3; 23) and formed on top of the light absorbing layer (3; 23),

a second window layer (5; 25) of the same semiconductor as that of the first window layer (4; 24), doped with an impurity of the same conductivity type as the impurity of the first window layer (4; 24), to a concentration higher than that of the first window layer (4; 24), and formed on a limited area of the top surface of the first window layer (4; 24),

a first electrode (13; 33) electrically connected to an upper region (6; 26), of the second window layer (5; 25), and

a second electrode (12; 32) electrically connected to the underside of the substrate (1; 21),

the upper region (6; 26) of the second window layer (5; 25) being doped with an impurity of a conductivity type different from that of the impurity of the second window layer (5; 25), to a relatively high concentration, to provide a p-n junction (10; 30) for avalanche multiplication and to provide a light sensitive region (6; 26),

the perimeter of the second window layer (5; 25) and an upper region of the first window layer (4; 24) surrounding the perimeter of the second window layer (5; 25) being doped with an impurity of the same conductivity type as that of the upper region (6; 26) of the second window layer (5; 25) to a relatively high concentration, and to a depth a specific distance above the heterojunction (11) between the light absorbing layer (3; 23) and the first window layer (4; 24), to provide a p-n junction (9; 29), for a guard ring effect, at the specific distance above the said heterojunction (11), which distance is sufficient to prevent tunnelling current from occurring in the region between the p-n junction (9; 29) for a guard ring effect and the said heterojunction (11),

2. An avalanche photodiode as claimed in claim 1, in which the light absorbing layer (3; 23) is of InGaAsP or InGaAs, for example doped with an n-type impurity, or is of GaSb, and the first window layer (4; 24) is of InP, for example doped with an n-type impurity, or is of GaAsSb.

3. An avalanche photodiode as claimed in claim 1 or 2, in which the said specific distance is approximately 0.5 micrometers, and the distance from the p-n junction (10; 30) for avalanche multiplication to the said heterojunction (11) is approximately 1.5 micrometers.

4. A method of producing an avalanche photodiode, the method comprising:
a step for growing a light absorbing layer (3; 23) of a semiconductor doped with an impurity of one conductivity type, on top of a semiconductor substrate (1; 21) of the photodiode, or on top of a buffer layer (2; 22) grown on top of the substrate (1; 21),

a step for growing a first window layer (4; 24) of a semiconductor having a larger band gap than that of the semiconductor of the light absorbing layer (3; 23) and which is doped with an impurity of the same conductivity type as that of the light absorbing layer (3; 23), to a concentration at least similar to that of the light absorbing layer (3; 23), on top of the light absorbing layer (3; 23),

a step for growing a second window layer (5; 25) of the same semiconductor as that of the first window layer (4; 24) and which is doped with an impurity of the same conductivity type as that of the first window layer (4; 24), to a concentration higher than that of the first window layer (4; 24), on top of the first window layer (4; 24),

a step for removing a limited portion of the second window layer (5; 25) to produce a mesa configuration for the second window layer (5; 25),

a step for providing a relatively high doping concentration of an impurity of a different conductivity type from that of the second window layer (5; 25) in an upper region (6; 26) of the mesa of the second window layer (5; 25) and in an upper region (28) of the first window layer (4; 24) surrounding the mesa of the second window layer (5; 25), to provide a p-n junction (9; 29), for a guard ring effect, between the said upper region (28) of the first window layer (4; 24) and a lower region of the first window layer (4; 24) at a specific distance above the heterojunction (11) between the light absorbing layer (3; 23) and the first window layer (4; 24), which distance is sufficient to prevent tunnelling current from occurring in the region between the said p-n junction (9; 29) and the said heterojunction (11),

a step for growing a first electrode (13; 33) electrically connected to the upper region (6; 26) of the mesa of the second window layer (5; 25), and

a step for growing a second electrode (12; 32) electrically connected to the under side of the substrate (1; 21).

5. A method as claimed in claim 4, wherein the substrate (1; 21) is doped with an impurity of the same conductivity type as the impurity with which the light absorbing layer (3; 23) is doped.

6. A method as claimed in claim 4 or 5, in which the light absorbing layer (3; 23) is of InGaAsP or InGaAs, for example doped with an n impurity, or is of GaSb, and the first window layer (4; 24) is of InP, for example doped with an n-type impurity, or is of GaAsSb.

7. A method as claimed in claim 4, 5 or 6, in which the said upper region (28) of the first window layer (4; 24) extends to a depth approximately 0.5 micrometers above the heterojunction (11) between the light absorbing layer (3; 23) and the first window layer (4; 24) and the said upper region (6; 26) of the mesa of the second window layer (5; 25) extends to a depth approximately 1.5 micrometers above the said heterojunction (11).

**Revendications**

1. Photodiode à avalanche comprenant:
une couche d'absorption de lumière (3; 23) faite d'un semiconducteur dopé à l'aide d'une impureté d'un premier type de conductivité, la couche d'absorption de lumière (3; 23) ayant été formée par croissance sur le dessus d'un substrat semiconducteur (1; 21) de la photodiode ou sur le dessus d'une couche tampon (2; 22) que l'on a fait croître sur le dessus du substrat (1; 21),

une première couche à fenêtre (4; 24) faite d'un semi-conducteur possédant une bande interdite plus grande que celle de la couche d'absorption de lumière (3; 23), dopée à l'aide d'une impureté du même type de conductivité que l'impureté de la couche d'adsorption de lumière (3; 23), à une concentration au moins analogue à celle de la couche d'absorption de lumière (3; 23), et formée sur le dessus de la couche d'absorption de lumière (3; 23),

une deuxième couche à fenêtre (5; 25) faite du même semiconducteur que la première couche à fenêtre (4; 24), dopée à l'aide d'une impureté du même type de conductivité que l'impureté de la première couche à fenêtre (4; 24), une concentration supérieure à celle de la première couche à fenêtre (4; 24), et formée sur une aire limitée de la surface de dessus de la première couche à fenêtre (4; 24),

une première électrode (13; 33) électriquement connectée à une région supérieure (6; 26) de la deuxième couche à fenêtre (5; 25), et

une deuxième électrode (12; 32) électriquement connectée à l'envers du substrat (1; 21),

la région supérieure (6; 26) de la deuxième couche à fenêtre (5; 25) étant dopée à l'aide d'une impureté d'un type de conductivé différent de celui de l'impureté de la deuxième couche à fenêtre (5; 25), à une concentration relativement élevée, afin de produire une jonction p-n (10; 30) servant à la multiplication par avalanche et afin de produire une région photosensible (6; 26),

le périmètre de la deuxième couche à fenêtre (5; 25) et une région supérieure de la première couche à fenêtre (4; 24) entourant le périmètre de la deuxième couche à fenêtre (5; 25) étant dopés à l'aide d'une impureté du même type de conductivité que la région supérieure (6; 26) de la deuxième couche à fenêtre (5; 25) jusqu'à une concentration relativement élevée et une profondeur correspondant à une distance spécifique au-dessus de l'hétérojonction (11) existant entre la couche d'absorption de lumière (3; 23) et la première couche à fenêtre (4; 24), afin de produire une jonction p-n (9; 29), servant à réaliser un effet d'anneau de garde, à une distance spécifique au-dessus de ladite hétérojonction (11), laquelle distance est suffisante pour empêcher qu'un courant de tunnel ne se produise dans la région se trouvant entre la jonction p-n (9; 29) servant à l'effet d'anneau de garde et ladite hétérojonction (11).

2. Photodiode à avalanche selon la revendication 1, où la couche d'absorption de lumière (3; 23) est faite de InGaAsP ou de InGaAs, par exemple dopé à l'aide d'une impureté du type n, ou est faite de GaSb, et la première couche à fenêtre (4; 24) est faite de InP, par exemple dopé à l'aide d'une impureté de type n, ou est faite de GaAsSb.

3. Photodiode à avalanche selon la revendication 1 ou 2, où ladite distance spécifique est d'environ 0,5 µm, et ladite distance de ladite jonction p-n (10; 30) servant à la multiplication par avalanche jusqu'à ladite hétérojonction (11) est d'environ 1,5 µm.

4. Procédé de production d'une photodiode à avalanche, le procédé comprenant:

une opération consistant à faire croître une couche d'absorption de lumière (3; 23) faite d'un semiconducteur dopé à l'aide d'une impureté d'un premier type de conductivité sur le dessus d'un substrat semiconducteur (1; 21) de la photodiode, ou sur le dessus d'une couche tampon (2; 22) que l'on a fait croître sur le dessus du substrat (1; 21),

une opération servant à faire croître une première couche a fenêtre (4; 24) faite d'un semiconducteur ayant une bande interdite plus grande que celle du semiconducteur de la couche d'absorption de lumière (3; 23) et qui est dopée à l'aide d'une impureté du même type de conductivité que la couche d'absorption de lumière (3; 23), à une concentration au moins analogue à celle de la couche d'absorption de lumière (3; 23), sur le dessus de la couche d'absorption de lumière (3; 23),

une opération servant à faire croître une deuxième couche à fenêtre (5; 25) faite du même semiconducteur que la première couche à fenêtre (4; 24) et qui est dopée à l'aide d'une impureté du même type de conductivité que la première couche à fenêtre (4; 24), avec une concentration supérieure à celle de la première couche à fenêtre (4; 24), sur le dessus de la première couche à fenêtre (4; 24),

une opération servant à enlever une partie limitée de la deuxième couche à fenêtre (5; 25) afin de produire une configuration en mesa pour la deuxième couche à fenêtre (5; 25),

une opération servant à produire une concentration à dopage relativement fort en une impureté d'un type de conductivité différent de celui de la deuxième couche à fenêtre (5; 25) dans une région supérieure (6; 26) de la mesa de la deuxième couche à fenêtre (5; 25) et dans une région supérieure (28) de la première couche à fenêtre (4; 24) entourant la mesa de la deuxième couche à fenêtre (5; 25), afin de produire une jonction p-n (9; 29), servant à réaliser un effet d'anneau de garde, entre ladite région supérieure (28) de la première couche à fenêtre (4; 24) et une région inférieure de la première couche à fenêtre (4; 24) à une distance spécifique au-dessus de l'hétérojonction (11) existant entre la couche d'absorption de lumière (3; 23) et la première couche à fenêtre (4; 24), laquelle distance est suffisante pour empêcher qu'un courant de tunnel ne se produise dans la région située entre ladite jonction p-n (9; 29) et ladite hétérojonction (11),

une opération servant à faire croître une première électrode (13; 33) électriquement connectée à la région supérieure (6; 26) de la mesa de la deuxième couche à fenêtre (5; 25), et

une opération servant à faire croître une deuxième électrode (12; 32) électriquement connectée à l'envers du substrat (1; 21).

5. Procédé selon la revendication 4, où le substrat (1; 21) est dopé à l'aide d'une impureté du même type de conductivité que l'impureté à l'aide de laquelle la couche d'absorption de lumière (3; 23) est dopée.

6. Procédé selon la revendication 4 ou 5, où la couche d'absorption de lumière (3; 23) est faite de InGaAsP ou InGaAs, par exemple dopé à l'aide d'une impureté n, ou est faite de GaSb, et la première couche à fenêtre (4; 24) est faite de InP, par exemple dopé à l'aide d'une impureté de type n, ou est faite de GaAsSb.

7. Procédé selon la revendication 4, 5 ou 6, où ladite région supérieure (28) de la première couche à fenêtre (4; 24) s'étend jusqu'à une profondeur d'environ 0,5 µm au-dessus de l'hétérojonction (11) existant entre la couche d'absorption de lumière (3; 23) et la première couche à fenêtre (4; 24), et ladite région supérieure (6; 26) de la mesa de la deuxième couche à fenêtre (5; 25) s'étend jusqu'à une prodondeur d'environ 1,5 µm au-dessus de ladite hétérojonction (11).

**Patentansprüche**

1. Lawinen-Fotodiode mit:

einer, aus einem mit Verunreinigungen eines Leitfähigkeitstyps dotierten Halbleiter bestehenden, lichtabsorbierenden Schicht (3; 23), die auf der Oberseite eines Halbleitersubstrats (1; 21) der Fotodiode aufgewachsen ist oder auf der Oberseite einer Pufferschicht (2; 22) die auf der Oberseite des Substrats (1; 21) aufgewachsen ist;

einer ersten Fensterschicht (4; 24), die aus einem Halbleiter besteht, dessen Bandabstand größer als derjenige der lichtabsorbierenden Schicht (3; 23) ist, die mit einer Verunreinigung vom selben Leitfähigkeitstyp wie die Verunreinigung der lichtabsorbierenden Schicht (3; 23) auf eine Konzentration dotiert ist, die wenigstens derjenigen der lichtabsorbierenden Schicht (3; 23) ähnlich ist und die auf der Oberseite der lichtabsorbierenden Schicht (3; 23) gebildet ist;

einer zweiten Fensterschicht (5; 25), aus demselben Halbleiter wie die erste Fensterschicht (4; 24), die mit einer Verunreinigung vom selben Leitfähigkeitstyp wie die Verunreinigung der ersten Fensterschicht (4; 24) auf eine Konzentration dotiert ist, die höher ist als diejenige der ersten Fensterschicht (4; 24), und die auf einem begrenzten Bereich auf der oberen Oberfläche der ersten Fensterschicht (4; 24) gebildet ist,

einer ersten Elektrode (13; 33), die elektrisch mit einem oberen Bereich (6; 26) der zweiten Fensterschicht (5; 25) verbunden ist, und

einer zweiten Elektrode (12; 32), die elektrisch mit der Unterseite des Substrats (1; 21) verbunden ist,

wobei der obere Bereich (6; 26) der zweiten Fensterschicht (5; 25) mit einer Verunreinigung von einem Leitfähigkeitstyp, welcher von demjenigen der Verunreinigung der zweiten Fensterschicht (5; 25) verschieden ist, auf eine relativ hohe Konzentration dotiert ist, um einen p-n-Übergang (10; 30) für eine Lawinenvervielfachung und einen lichtempfindlichen Bereich (6; 26) zu bilden,

wobei der Umfang der zweiten Fensterschicht (5; 25) und ein oberer Bereich der ersten Fensterschicht (4; 24), welche den Umfang der zweiten Fensterschicht (5; 25) umgibt, mit einer Verunreinigung vom selben Leitfähigkeitstyp wie derjenigen des oberen Bereiches (6; 26) der zweiten Fensterschicht (5; 25) auf eine relativ hohe Konzentration und bis in eine Tiefe in einem spezifischen Abstand oberhalb des Heteroübergangs (11) zwischen der lichtabsorbierenden Schicht (3; 23) und der ersten Fensterschicht (4; 24) dotiert sind, um einen p-n-Übergang (9; 29) für einen Schutzringeffekt bei einem spezifischen Abstand oberhalb des genannten Heteroübergangs (11) vorzusehen, welcher Abstand ausreicht, um zu verhindern, daß ein Tunnelstrom in dem Bereich zwischen dem p-n-Übergang (9; 29) für einen Schutzringeffekt und dem genannten Heteroübergang (11) auftritt.

2. Lawinen-Fotodiode nach Anspruch 1, bei welcher die lichtabsorbierende Schicht (3; 23) aus InGaAsP oder InGaAs besteht, welches z. B. mit einer Verunreinigung vom n-Type dotiert ist, oder aus GaSb, und die erste Fensterschicht (4; 24) aus InP besteht, welches z. B. mit einer Verunreinigung vom n-Typ dotiert ist, oder aus GaAsSb.

3. Lawinen-Fotodiode nach Anspruch 1 oder 2, bei welcher der genannte spezifische Abstand etwa 0,5 Mikrometer beträgt und der Abstand von dem p-n-Übergang (10; 30) für die Lawinenvervielfachung zu dem genannten Heteroübergang (11) etwa 1,5 Mikrometer beträgt.

4. Verfahren zur Erzeugung einer Lawinen-Fotodiode mit:

einem Schritt zum Wachsen einer lichtabsorbierenden Schicht (3; 23) aus einem Halbleiter, der mit einer Verunreinigung von einem Leitfähigkeitstyp dotiert ist, auf der Oberseite eines Halbleitersubstrats (1; 21) der Fotodiode oder auf der Oberseite einer Pufferschicht (2; 22), die auf der Oberseite des Substrats (1; 21) aufgewachsen ist,

einem Schritt zum Aufwachsen einer ersten Fensterschicht (4; 24) aus einem Halbleiter, dessen Bandabstand größer als derjenige des Halbleiters der lichtabsorbierenden Schicht (3; 23) und der mit einer Verunreinigung vom selben Leitfähigkeitstyp wie derjenigen der lichtabsorbierenden Schicht (3; 23) auf eine Konzentration dotiert ist, die wenigstens ähnlich derjenigen der lichtabsorbierenden Schicht (3; 23) ist, auf der Oberseite der lichtabsorbierenden Schicht (3; 23), einem Schritt zum Aufwachsen einer zweiten Fensterschicht (5; 25) aus demselben Halbleiter wie derjenige der ersten Fensterschicht (4; 24) und welche mit einer Verunreinigung vom selben Leitfähigkeitstyp wie demjenigen der ersten Fensterschicht (4; 24) auf eine Konzentration dotiert ist, die höher als diejenige der ersten Fensterschicht (4; 24) ist, auf der Oberseite der ersten Fensterschicht (4; 24),

einem Schritt zur Entfernung eines begrenzten Abschnitts von der zweiten Fensterschicht (5; 25), um eine Mesakonfiguration für die zweite Fensterschicht (5; 25) zu erzeugen,

einem Schritt zur Erzeugung einer relativ hohen Dotierungskonzentration von einer Verunreinigung von einem Leitfähigkeitstyp, der von demjenigen der zweiten Fensterschicht (5; 25) verschieden ist, in einem oberen Bereich (6; 26) von dem Mesa der zweiten Fensterschicht (5; 25) und in einem oberen Bereich (28) der ersten Fensterschicht (4; 24), welche das Mesa der zweiten Fensterschicht (5; 25) umgibt, um einen p-n-Übergang (9; 29) für einen Schutzringeffekt zwischen dem genannten oberen Bereich (28) der ersten Fensterschicht (4; 24) und einem unteren Bereich der ersten Fensterschicht (4; 24) in einem spezifischen Abstand oberhalb des Heteroübergangs (11) zwischen der lichtabsorbierenden Schicht (3; 23) und der ersten Fensterschicht (4; 24) zu erzeugen, welcher Abstand ausreicht, um zu verhindern, daß ein Tunnelstrom in dem Bereich zwischen dem genannten p-n-Übergang (9; 29) und dem genannten Heteroübergang (11) auftritt,

einem Schritt zum Aufwachsen einer ersten Elektrode (13; 33), die elektrisch mit dem oberen Bereich (6; 26) des Mesa der zweiten Fensterschicht (5; 25) verbunden ist, und

einem Schritt zum Aufwachsen einer zweiten Elektrode (12; 32), die elektrisch mit der unteren Seite des Substrats (1; 21) verbunden ist.

5. Verfahren nach Anspruch 4, bei welchem das Substrat (1; 21) mit einer Verunreinigung vom selben Leitfähigkeitstyp dotiert ist, wie die Verunreinigung, mit welcher die lichtabsorbierende Schicht (3; 23) dotiert ist.

6. Verfahren nach Anspruch 4 oder 5, bei welchem die lichtabsorbierende Schicht (3; 23) aus InGaAsP oder InGaAs, z. B. mit einer n-Verunreinigung dotiert ist, oder aus GaSb besteht, und die erste Fensterschicht (4; 24) aus InP, z. B. dotiert mit einer Verunreinigung vom n-Typ, oder aus GaAsSb ist.

7. Verfahren nach Anspruch 4, 5 oder 6, bei welchem der obere Bereich (28) der ersten Fensterschicht (4; 24) sich bis in eine Tiefe ungefähr 0,5 Mikrometer oberhalb des Heteroübergangs (11) zwischen der lichtabsorbierenden Schicht (3; 23) und der ersten Fensterschicht (4; 24) erstreckt, und der genannte obere Bereich (6; 26) des Mesa der zweiten Fensterschicht (5; 25) sich bis zu einer Tiefe etwa 1,5 Mikrometer oberhalb des genann-ten Heteroübergangs (11) erstreckt.

# Fig. 1

5
4
3
2
1

# Fig. 2

7    6    7
5
4
3
2
1

## Fig. 3

## Fig. 4

# Fig. 5

# Fig. 6

## Fig. 7

## Fig. 8

## Fig. 9

## Fig. 10

## Fig. 11

## Fig. 12

# Fig. 13